# EUROPEAN PATENT SPECIFICATION

(11) **EP 3 717 675 B1**
(45) Date of publication and mention of the grant of the patent: **21.09.2022**
(21) Application number: 17933351.3
(22) Date of filing: 01.12.2017
(51) Int. Cl.: C23C 14/24, C23C 14/50, C23C 14/56, H01L 31/20

(54) **PHYSICAL VAPOR DEPOSITION SYSTEM COMPRISING POSITIONING MARKER AND METHOD FOR ADJUSTING DISTANCE BETWEEN CRUCIBLE AND SUBSTRATE**
SYSTEM ZUR PHYSIKALISCHEN DAMPFABSCHEIDUNG MIT POSITIONIERUNGSMARKIERUNG UND VERFAHREN ZUR EINSTELLUNG DES ABSTANDES ZWISCHEN TIEGEL UND SUBSTRAT
SYSTÈME DE DÉPÔT PHYSIQUE EN PHASE VAPEUR COMPRENANT UN MARQUEUR DE POSITIONNEMENT ET PROCÉDÉ POUR LE RÉGLAGE DE LA DISTANCE ENTRE UN CREUSET ET UN SUBSTRAT

(43) Date of publication of application: 07.10.2020
(73) Proprietor: China Triumph International Engineering Co., Ltd., Shanghai 200063 (CN); CTF Solar GmbH, 01099 Dresden (DE)
(72) Inventor: PENG, Shou, Shanghai 200063 (CN); HARR, Michael, 01109 Dresden (DE); YIN, Xinjian, Shanghai 200063 (CN); FU, Ganhua, 01109 Dresden (DE); SPATH, Bettina, 01109 Dresden (DE); MISCHKE, Marcel, 01109 Dresden (DE); SIEPCHEN, Bastian, 01109 Dresden (DE)
(74) Representative: Kailuweit & Uhlemann Patentanwälte Partnerschaft mbB
(86) International application number: PCT/CN2017/114304
(87) International publication number: WO 2019/104727

(56) References cited:
- EP-A2- 1 160 880
- CN-A- 102 234 762
- CN-A- 105 940 140
- US-A1- 2009 258 134
- US-A1- 2011 255 950
- US-A1- 2014 044 863
- US-B1- 6 444 043

## Description

The invention relates to a physical vapor deposition system comprising a positioning marker which is suited for determining the distance between a crucible and a substrate and to a method for adjusting a distance between the crucible and the substrate within such a system.

In the production of semiconductor devices, for instance in production of solar cells, films are often deposited by evaporation or sublimation or sputtering, wherein the material to be evaporated, sublimated or sputtered, in the following called as source material, is provided in a crucible. The crucible may be arranged above or beneath a substrate on which a film is to be deposited. For the quantity and quality of the deposited film and in the result for the characteristics of the deposited film, the distance between the substrate surface on which the film is deposited and the crucible, in particular the surface of the source material within the crucible, is very important. Furthermore, this distance should be homogeneous across the whole lateral extension of the film deposition area on the substrate surface.Typical distances for sputtering or evaporation are 50 mm to 500 mm, whereas a close space sublimation process (CSS) is performed with a distance in the range from 2 mm to 50 mm.Most of the evaporation, sublimation or sputtering processes are performed under environmental conditions differing from normal conditions (room temperature, normal air pressure). For instance, the substrate and/or the crucible may be heated to a temperature in the range between 200°C to 600°C and the pressure inside a process chamber used for physical vapor deposition is often decreased by a certain degree. For instance, to anabsolute pressure in the range of 1 mbar to 10⁻⁶ mbar.

The distance between the crucible and the substrate (or a substrate holding position) is often adjusted under environmental conditions differing from the environmental conditionsduring the deposition process. In particular, the distance is often adjusted while the process chamber is open and the substrate holder or the substrate and/or the crucible are cold. In the result, the distance between the crucible and the substrateduring processing may differ from the adjusted distance due to other environmental conditions during processing. Furthermore, the distance between the crucible and the substrate should be alterable also during processing in order to react on decreasing amount of the source material present in the crucible or in order to adapt the distance due to different process conditions or different desired characteristics of the layer to be formed.

One approach for adapting the distance between the substrate and the surface of the source material within the crucible is to alter the height of the surface of the source material within the crucible. In WO 2011/131172 A2, a sputtering crucible is described, wherein the source material within the crucible may be pushed up by a lifting device in form of a spindle drive arranged below the crucible such that the surface of the source material is always on the same height with respect to the substrate. For liquid materials which are present in evaporation devices, DE 10 2012 109 626 A1 discloses different methods for changing the height of the source material surface within the crucible. Some of these methods comprise refilling source material into the crucible, while another method includes providing a displacer which is submerged into the melted source material to a specific degree in order to adjust the height of the source material surface.

Another approach for adapting the distance between the substrate and the crucible is to alter the position of the substrate surface. In this case lift mechanisms changing the position of the substrate with respect to the crucible may be used as known from US 2017/0018413 A1 or DE 10 2012 109 626 A1, for instance.

However, these methods have different disadvantages. For instance, lifting the material within the crucible may be done only for solid materials, i.e. not in evaporation. Further, refilling material into the crucible or submerging a displacer may be difficult and/or imprecise or demand a complex auxiliary structure. Changing the position of the substrate within the process chamber may be complicated if substrates are moved above the crucible like in an inline chamber, where one substrate after another move from an inlet of the process chamber across the crucible to an outlet of the process chamber and wherein a transport system within the process chamber corresponds with one or more transport systems outside the process chamber. Moreover, it may be difficult to determine the real distance or to change the distance between the substrate and the crucible while the process chamber is closed and at process conditions. Also,achieving a homogeneous alignment between the substrate surface and the source material surface in order to bring the substrate surface in parallel to the surface of the source material may be demanding.

Each of US 2011/255950 A1, US 6 444 043 B1 and EP 1 160 880 A2 discloses a so called close-space sublimation (CSS) process, which is a process, where the substrate to be coated and the source material are held close to one another and where parallel alignment of the crucible and the substrate are important for a homogeneous film thickness. They all disclose a small distance between the crucible and the substrate and means for moving one or the other in a vertical direction to create the desired distance between them.

It is an object of the invention to provide a simple physical vapor deposition system which is suited for determining and adjusting the distance between the crucible and the substrate even under processing conditions and a simple method for adjusting the distance between the crucible and the substrate.

This object is solved by the system and the method according to the independent claims.

Preferred embodiments are given in the dependent claims.

The physical vapor deposition system comprises a crucible for holding a source material, a substrate holder for holding a substrateand a moving device for moving the crucible or the substrate holder. This moving device is suited to change the distance between a first surface of the crucible and a first surface of the substrate holder whichcorresponds to a deposition surface of a substrate when held in the substrate holder.The distance is measured along a first direction connecting the first surface of the crucible and the first surface of the substrate holder. Furthermore, the moving device may be suited to position the crucible or the substrate holder such that a first surface of the crucible and a first surface of the substrate holder are parallel to each other during physical vapor deposition.

The first surface of the crucible and the first surface of the substrate holder are defined such that the first surface of the crucible and a deposition surface of a substrate held in the substrate holder lie opposite to each other during the physical vapor deposition process. That is, the first surface of the crucible is that surface of the crucible from which a source material is provided and moves towards a deposition surface of a substrate. In one embodiment, a recess or opening is formed within the first surface of the crucible, in which the source material is provided and from which the source material directly moves toward the substrate.The crucible may have any overall and any lateral form, i.e. the first surface may have a round, a circular, an oval, a triangular, a rectangular or any other polygonal or unangled contour in a plan view on the first surface. The same applies to the contour of the recess or the opening for the source material in a plan view on the first surface, wherein the shape of the contour of the recess or the opening may be different from or equal to the shape of the contour of the first surface of the crucible. In another embodiment, the source material may be evaporated or sublimated and the gaseous source material is directed via channels and a transmitting device towards a substrate. In that case, the transmitting device is understood as a part of the crucible in the sense of the invention and a surface of the transmitting device from which the source material is leaving towards the substrate is understood as the first surface of the crucible.

The substrate holder may be any device or system suited to hold a substrate during a deposition process. It may be a transport system, e.g. shafts or rolls on which the substrate is arranged and moved over or beneath the crucible, or may be a stationary or movable device for holding the substrate at a position above or beneath the crucible. Also other positions, for instance oblique or perpendicular arrangements of the crucible and the substrate holder within the process chamber may be possible, for instance, if the source material is solid and deposited on the substrate by sputtering. In any way, the first surface of the substrate holder has a portion, e.g. a recess or an opening,in which the deposition surface of the substrate is accessible for the source material sputtered or evaporated or sublimated from the crucible.

The moving device may be any device suited to perform the objectsmentioned above. It may, for instance, be a lift mechanism which may comprise a tilting mechanismor it may comprise at least three screws by which the crucible or the substrate holder may be moved along the first direction and by which the crucible or the substrate holder may be tilted. It is sufficient if the moving device may move only the crucible or only the substrate holder, while the other one of the crucible or the substrate holder is fixed with respect to the first direction. However, the moving device may also be suited to move both the crucible and the substrate holder or the physical vapor deposition system comprises two moving devices, wherein one moving device is suited to move the crucible and the other moving device is suited to move the substrate holder in the manner described above.

The physical vapor deposition system according to the invention further comprises at least one positioning marker which is arranged in a fixed manner at the crucible or at the substrate holder such that it protrudes intoa space between the crucible and the substrate holder, i.e. into the first direction. The positioning marker has a stepped contour with at least two different step levels. Each of the different step levels has an individual height with respect to the first surface of the crucible and is positioned in parallel to the first surface of the crucible if the positioning marker is arranged at the crucible or has an individual height with respect to the first surface of the substrate holder and is positioned in parallel to the first surface of the substrate holder if the positioning marker is arranged at the substrate holder, wherein the individual heights are different from each other.

Using the positioning marker, the distance between the first surface of the crucible and the first surface of the substrate holder or the deposition surface of a substrate when held in the substrate holder may be adjusted. If, for instance, the positioning marker is arranged at the crucible, a first distance is reached, when the first surface of the substrate holder or the deposition surface of the substrate are positioned at the height of a first step level of the positioning marker. And a second distance is reached, when the first surface of the substrate holder or the deposition surface of the substrate are positioned at the height of a second step level of the positioning marker. Thus, the positioning marker is suited to mark at least two different positions or distances of the deposition surface of a substrate when held in the substrate holder with respect to the first surface of the crucible.

The positioning marker may be arranged on the first surface of the crucible or of the substrate holder or may be arranged on a side surface of the crucible or of the substrate holder, wherein the side surface adjoins the first surface of the crucible or of the substrate holder, respectively. The positioning marker may be a separate device mounted in a fixed manner to the crucible or the substrate holder or may be formed integrally with the crucible or the substrate holder. The positioning marker is characterized by at least two individual heights measured along the first direction, i.e. perpendicular to the first surface of the crucible or the substrate holder, respectively, wherein each individual height corresponds to one of the step levels. Furthermore, the positioning marker is characterized by a total length and at least two individual lengths measured along a second direction which is perpendicular to the first direction and parallel to the first surface of the crucible or the substrate holder, respectively. Each individual length corresponds to one of the step levels. The first direction and the second direction span a plane, wherein the stepped contour of the positioning marker can be seen in a view on that plane. Furthermore, the positioning marker has at least one depth measured along a third direction perpendicular to the first and the second direction and parallel to the first surface of the crucible or the substrate holder, respectively.

The individual heights correspond to individual distances between the first surface of the crucible and the first surface of the substrate holder or the deposition surface of a substrate held in the substrate holder and may be, for instance, values in a range between 50 mm to 500 mm in case of sputtering or evaporation, or in a range between 2 mm to 50 mm in case of closed space sublimation, wherein the spaces may be, for instance 5 mm or 10 mm or any other suitable value. The heights may be equally spaced or the spaces may be different for different step levels and the individual heights may be chosen according to the needs of the performed physical vapor deposition process.

The individual lengths may be equal to or different from each other. Preferably, the individual lengths are chosen such that a tilting of the crucible or of the substrate holder or of a substrate held in the substrate holder in the second direction may be identified if it exists. Suitable individual lengths lie in the range from 50mm to 500 mm.

The depth of the positioning marker may lie in the range from 5 mm to 80 mm. If a tilting of the crucible or of the substrate holder or of a substrate held in the substrate holder in the third direction should be identified only by one positioning marker, the depth should be at least 10 mm.

In an embodiment, the physical vapor deposition system comprises at least a first positioning marker and a second positioning marker, wherein the first and the second positioning markers are formed in the same way and are arranged in parallel to each other at opposite sides of the crucible or at opposite sides of the substrate holder. In other words, the planes spanned by the first direction and the second direction for the first and the second positioning markers are arranged in parallel. Thus, a tilting of the crucible or of the substrate holder or of a substrate held in the substrate holder in the second direction or in the third direction can be identified if it exists, even if the individual lengths or the depth of the positioning markers are small and not suited to certainly identify a tilting by using only one positioning marker.

In a special embodiment, the first positioning marker and the second positioning marker are positioned in a shifted manner with respect to each other. That is, the first positioning marker and the second positioning marker are not only positioned on opposite sides of the crucible or of the substrate holder, but are also shifted to each other along the third direction if the opposite sides are arranged along the second direction, or are shifted to each other along the second direction if the opposite sides are arranged along the third direction. Preferably for a quadrangular crucible or a quadrangular substrate holder, the first positioning marker and the second positioning marker are positioned such that they adjoin corners of the crucible or of the substrate holder which lie diagonally opposite to each other.

In one embodiment, the crucible, the substrate holder and the positioning marker are positioned in a process chamber, wherein the process chamber has a viewport suited for a visual inspection of a position of the first surface of the crucible or of the first surface of the substrate holder or of a deposition surface of a substrate when held in the substrate holder with respect to one of the at least two step levels of the positioning marker while the process chamber is closed. Through the viewport, the distance between the first surface of the crucible and the first surface of the substrate holder or the deposition surface of the substrate can be inspected and controlled with the help of the positioning marker, even if the process chamber is closed. Thus, the distance can be adjusted when the process chamber is at process conditions or even during a deposition process. "Visual inspection" means that an operator may view through the viewport and control the distance by his eyes or that a camera is positioned at the viewport which takes images or transfers images of the positions of the first surface of the substrate holder or of a deposition surface of a substrate when held in the substrate holderwith respect to the first surface of the crucible. These images may be evaluated by an operator or a machine controlling the moving device.

The method for adjusting a distance between a crucible and a substrate in a physical vapor deposition system according to the invention comprises providing the physical vapor deposition system according to the invention and moving the crucible or the substrate holder such that the first surface of the crucible or the first surface of the substrate holder or a deposition surface of a substrate held in the substrate holder are aligned with one of the step levels of the at least one positioning marker when seen in a side view on the positioning marker and the crucible, the substrate holder or the substrate. Thus, the distance between the crucible and the deposition surface of the substrate may be adjusted at least at two stages corresponding to the at least two step levels of the positioning marker. Furthermore, also a tilting of the crucible, the substrate holder or the substrate may be identified and eliminated. If the process chamber of the physical vapor deposition system has a viewport, this can be done even when the process chamber is closed and at process conditions or even during a deposition process. In the result, a simple method for adjusting a distance between the crucible and the deposition surface of the substrate in a stepped manner is provided.

The accompanying drawings are included to provide a further understanding of embodiments of the invention and are incorporated in and constitute a part of this specification. The drawings illustrate the embodiments of the present invention and together with the description serve to explain the principles. The elements of the drawings are not necessarily to scale relative to each other. Like reference numbers designate corresponding similar parts.
- Fig. 1: shows a schematic perspective view on a first embodiment of the physical vapor deposition system according to the invention,
- Fig. 2: shows a schematic side view on the first embodiment of Fig. 1.
- Fig. 3: shows a schematic front view on the first embodiment of Fig. 1, wherein the physical vapor deposition system is arranged in a process chamber,
- Fig. 4: shows a schematic side view on a second embodiment of the physical vapor deposition system according to the invention,
- Fig. 5: shows a schematic side view on the second embodiment of Fig. 4, wherein the crucible is tilted with respect to the second direction, and
- Fig. 6: shows a schematic side view on the second embodiment of Fig. 4, wherein the crucible is tilted with respect to the third direction.

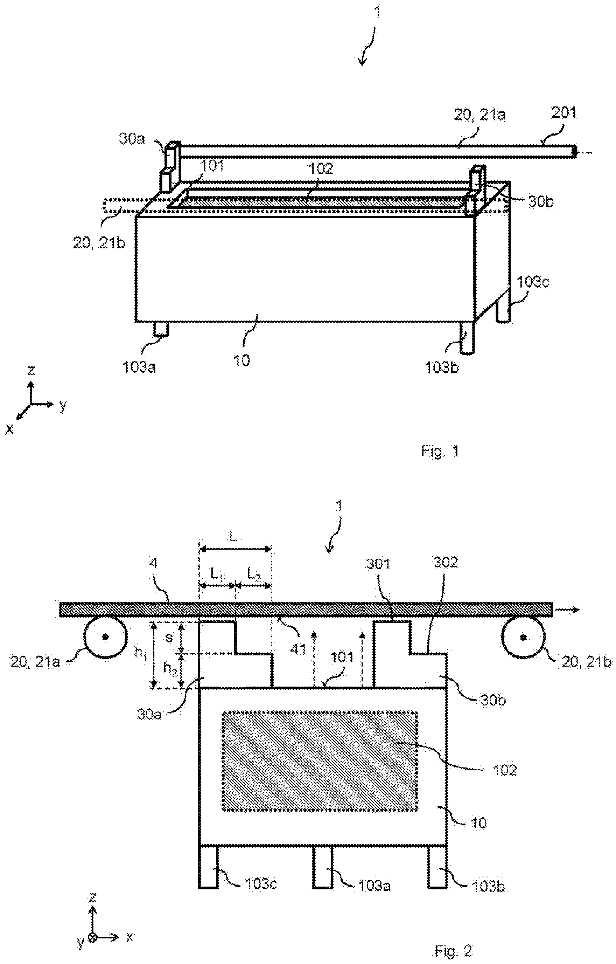

Figure 1 shows a schematic perspective view on a first embodiment 1 of the physical vapor deposition system according to the invention. The physical vapor deposition system 1 is an evaporation system and comprises a crucible 10 and a substrate holder 20. The crucible 10 is essentially a cuboid and has a first surface 101,wherein a recess is formed in the first surface 101. In that recess, a source material 102 is provided which is sputtered, evaporated or sublimated and then moves towards the substrate holder 20. The source material 102 does not adjoin the first surface 101 of the crucible 10, i.e. it is recessed with respect to the first surface 101. Furthermore, during the deposition process, the surface of the source material 102 will even recess more due to the amount of the source material 102 which is transferred to a gaseous phase.

In the shown embodiment, the substrate holder 20 is arranged above the crucible 10 along a first direction (z-direction) and comprises two shafts 21a and 21b which are suited to rotate and to transport a substrate over the crucible 10 along a second direction (x-direction).Such a substrate is arranged or held on a first surface 201 of the substrate holder. Between the shafts 21a and 21b, a space or an opening is provided in which a deposition surface of the substrate is accessible to the gaseous source material 102 moving from the crucible 10 upwards. The shaft 21b in the front of the figure is shown only by a dashed contour in order to make the other elements of the physical vapor deposition system 1 better apparent. The rotation axis of the shafts 21a, 21b extend along a third direction (y-direction). The first, second and third directions are directions of a Cartesian coordinate system.

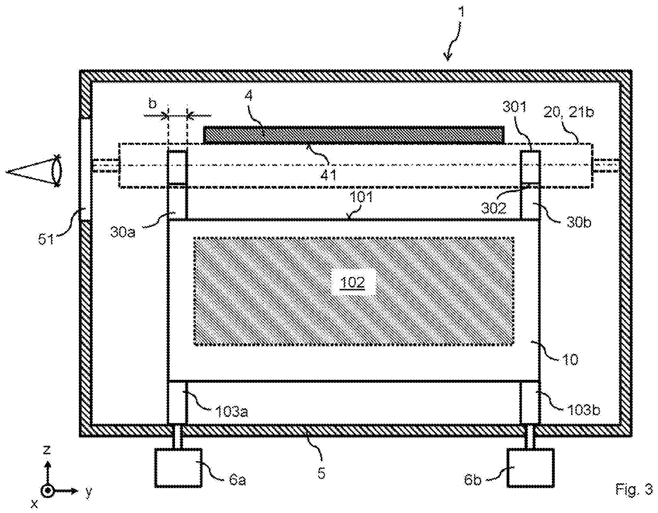

The crucible 10 is arranged on three bases 103a, 103b and 103c which can be moved or which length can be changed by a moving system which will be described with respect to Fig. 3. Thus, the crucible 10 may be moved along the first direction in the range between 2 mm to 500 mm and may also be tilted with respect to a plane defined by the second and the third directions (x-y-plane).

The physical vapor deposition system 1 further comprises two positioning markers: a first positioning marker 30a and a second positioning marker 30b. The positioning markers 30a and 30b are block structures which are formed integrally with the crucible 10, are arranged on the first surface 101 of the crucible 10 and extend along the first direction towards the substrate holder 20. The first positioning marker 30a is arranged at a first side of the first surface 101 and the second positioning marker 30b is arranged at a second side of the first surface 101, wherein the first side and the second side are opposite sides of the first surface 101 with respect to the third direction (y-direction). Furthermore, the first positioning marker 30a and the second positioning marker 30b are arranged in a shifted or staggered manner with respect to the second direction (x-direction). In particular, the first positioning marker 30a is arranged at a third side of the first surface 101 and the second positioning marker 30b is arranged at a fourth side of the first surface 101, wherein the third side and the fourth side are opposite sides of the first surface 101 with respect to the second direction (x-direction).

The first and the second positioning markers 30a and 30b are formed in the same way and have a stepped contour, that is they are formed like a staircase having at least two steps. This will be explained in more detail with respect to Figures 2 and 3.

Figure 2 is a schematic side view on the physical vapor deposition system 1 and shows the crucible 10, the substrate holder 20 with its two shafts 21a and 21b, a substrate 4 held by the substrate holder 20 and the positioning markers 30a and 30b. The source material 102 may not be seen in the side view, but is shown by dashed lines for better understanding. Here it can also be seen that the surface of the source material 102 is recessed with respect to the first surface 101 of the crucible 10 as described above. The source material 102 is evaporated and moves to a deposition surface 41 of the substrate 4 as shown by the two dashed arrows. The substrate 4 is moved along the second direction (x-direction) over the shafts 21a, 21b, which is indicated by the solid arrow.

The positioning markers 30a and 30b are blocks or solid structures having a stepped contour in the side view as can be seen in Fig. 2. In the shown embodiment, they each have two step levels: a first step level 301 and a second step level 302. Each step level 301 and 302 is a planar surface extending in parallel to the first surface 101 of the crucible 10 and having an individual height with respect to the first surface 101. That is: the first step level 301 has a first height h₁ measured from the first surface 101 along the first direction (z-direction) and the second step level 302 has a second height h₂ measured from the first surface 101 along the first direction, wherein the first height is larger than the second height (h₁> h₂). A space or distance s between the first step level 301 and the second step level 302 is defined as the difference between the first height h₁ and the second height h₂ and may also be called the rise of the step as in case of a stair. The first height may be double of the second height (h₁ = 2 • h₂), whereas the space s equals the second height h₂, or the first height h₁ may be any other value, whereas the space s may be smaller or larger than the second height h₂.

Each step level 301 and 302 has an individual length measured along the second direction (x-direction).That is: the first step level 301 has a first length L₁ and the second step level 302 has a second length L₂ and the whole positioning marker 30a, 30b has a whole length L which is the sum of all individual step lengths. Each individual step length may also be called the tread depth of the step as in case of a stair. The individual lengths may be equal or may differ from each other.

Figure 3 is a schematic front view on the physical vapor deposition system 1 and shows the crucible 10, the substrate 4 and the positioning markers 30a and 30b. Again, the source material 102 may not be seen in the side view, but is shown by dashed lines for better understanding. The positioning markers 30a and 30b each extend along the third direction (y-direction) with a depth b which is equal for all step levels 301 and 302 in the shown embodiment. As can be seen in Fig. 3, the positioning markers 30a and 30b are arranged outside a process zone where the sputtered, evaporated or sublimated source material 102 moves towards the substrate 4.Furthermore, a process chamber 5, in which most parts of the physical vapor deposition system 1 are arranged, is shown in Fig. 3.

The substrate holder 20 is shown only with one of its shafts, in particular with shaft 21b, which however lies in front of the shown plane of view and which is therefore only illustrated by a dashed line. The shafts of the substrate holder are mounted in walls of the process chamber 5. As can be seen, a viewport 51 is formed within a wall of the process chamber 5 at a position such that a side view on the positioning markers 30a and 30b and at least the deposition surface 41 of the substrate 4 is possible. In other words: An operator or a camera viewing through the viewport would see at least a part of the side view of Fig. 2. The viewport 51 is made of a transparent material, e.g. glass, and may be covered by a shutter arranged within the process chamber 5 when the distance between the substrate 4 and the crucible 10 has not to be adjusted. That is, most or all of the time of a deposition process, the viewport 51 is covered in order to prevent contamination of the viewport 51 by the gaseous source material 102.

As can be seen, the deposition surface 41 of the substrate 4 is arranged at a height above the first surface 101 of the crucible, which is larger than the first height h₁ as explained with respect to Fig. 2. If the distance between the deposition surface 41 and the first surface 101 should be changed, the substrate holder 20 or the crucible 10 has to be moved. In the shown embodiment, the crucible 10 can be moved using a moving device. Fig. 3 shows two moving devices 6a and 6b, wherein the moving device 6a acts on the base 103a and the moving device 6b acts on the base 103b. A third moving device not shown in Fig. 3 may act on the base 103c shown in Figures 1 and 2. Thus, each base may be affected individually and independently from the other bases. When moving the crucible 10 upwardly, the deposition surface 41 first aligns with the first step level 301. If the crucible 10 is moved further upwardly, the deposition surface 41 then aligns with the second step level 302. An operator or a camera viewing through the viewport 51 may control the movement of the crucible 10 such that the deposition surface 41 aligns with a desired step level. Furthermore, also a tilting of the deposition surface 41 with respect to the x-y-plane may be recognized and corrected.

Although only one viewport 51 is shown with respect to the first embodiment 1 of the physical vapor deposition system, also two or more viewports may be provided in the walls of the process chamber 5. For example, one viewport may be arranged within each of two opposite walls of theprocess chamber 5, i.e. the viewport 51 as shown in Fig. 3 and a further viewport in the opposite wall, wherein an operator or a camera can observe and control the distance and the alignment between the crucible 10 and the substrate holder 20 or the substrate 4 by a direct view on the second positioning marker 30b.

With respect to the first embodiment 1 of the physical vapor deposition system, only two different distances between the first surface 101 of the crucible 10 and the first surface 201 of the substrate holder 20 or the deposition surface 41 of the substrate 4 may be adjusted, since the positioning markers 30a and 30b comprise only two different step levels 301 and 302.

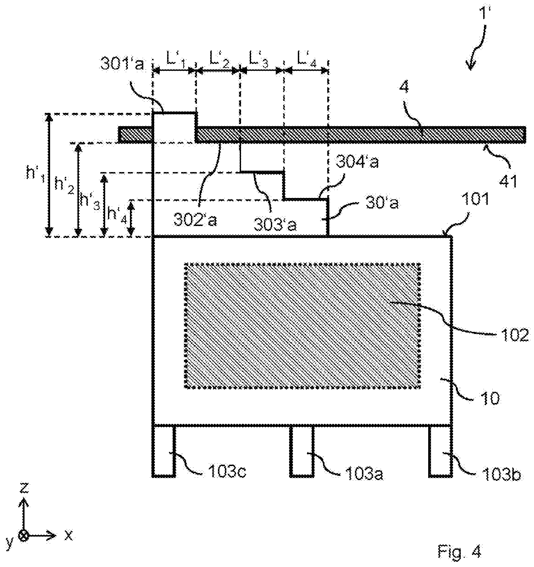

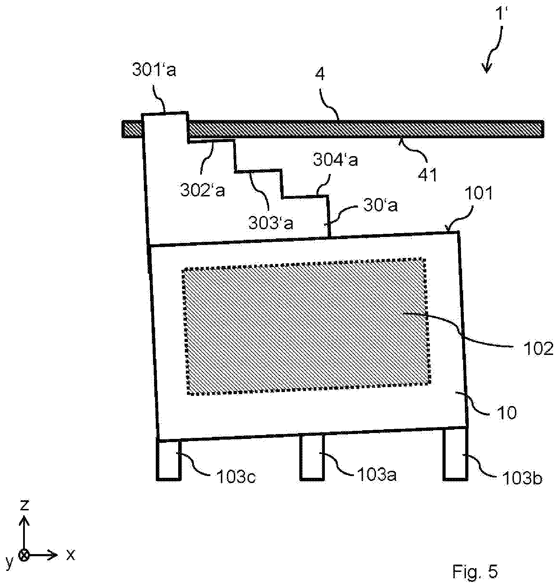

Figures 4 to 6 show a second embodiment 1' of the physical vapor deposition system according to the invention, wherein the positioning markers comprise more step levels. The second embodiment 1' also comprises two positioning markers 30'a and 30'b, wherein, however, only the first positioning marker 30'a can be seen in Figures 4 and 5, since the positioning markers 30'a and 30'b are not arranged in a shifted manner along the second direction (x-direction). Both positioning markers 30'a and 30'b are formed in the same way. The substrate holder as well as other components of the physical vapor deposition system 1', e.g. moving devices and a process chamber, are not shown.

As shown in Fig. 4 which is a side view on the physical vapor deposition system 1', the positioning marker 30'a has four step levels 301'a to 304'a, wherein each step level has an individual height h'₁ to h'₄ and an individual length L'₁ to L'₄. In the shown embodiment,all spaces between the different step levels are equal, for instance 5 mm, and all heights h'₁ to h'₄ are multiples of the space, for instance of 5 mm, wherein the factor is a whole-number value in the range between 1 to 4. Further, the individual lengthsL'₁ to L'₄ each are equal to each other. In Figure 4, the deposition surface 41 of the substrate 4 is aligned with the second step level 302'a and is further in parallel with the first surface 101 of the crucible 10. Therefore, the distance between the first surface 101 of the crucible 10 and the deposition surface 41 of the substrate 4 equals 15 mm, if the fourth height h'₄ is 5 mm and each space is 5 mm.

Figure 5 illustrates a case, where the substrate 4 and the crucible 10 are tilted with respect to each other in the second direction (x-direction), andshows a side view on the physical vapor deposition system 1'. In the present case, the bases 103a to 103c of the crucible 10 have different lengths, i.e. the bases 103a to 103c were not affected equally while the crucible 10 was moved upwardly or downwardly along the first direction. Therefore, the deposition surface 41 of the substrate 4 is not completely aligned with the second step level 302'a. This misalignment can be recognized by an operator or a camera viewing on the side of the physical vapor deposition system 1' and seeing at least a part of the view illustrated in Fig. 5. In the result, the operator or a controller may control a moving device acting on the crucible 10 such that the tilting of the crucible 10 is eliminated and the deposition surface 41 of the substrate 4 completely aligns with the second step level 302'a as shown in Fig. 4.

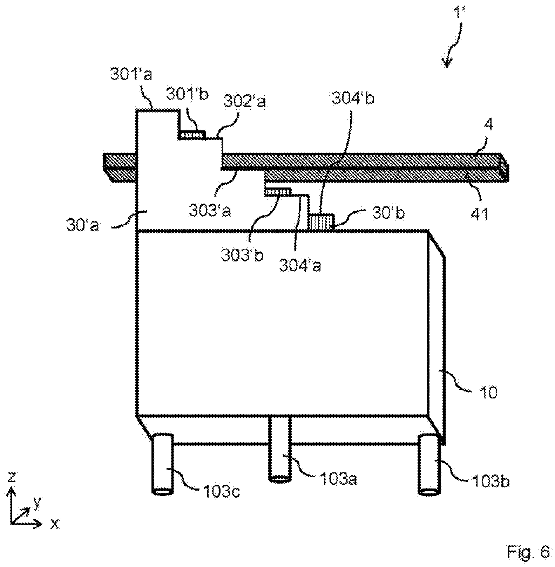

Figure 6 illustrates a case, where the substrate 4 and the crucible 10 are tilted with respect to each other in the third direction (y-direction), andshows a perspective view on the physical vapor deposition system 1'. In the present case, the base 103a of the crucible 10 has a different length as compared with the bases 103b and 103c, i.e. the base 103a on the one hand and the bases 103b and 103c on the other hand were not affected equally while the crucible 10 was moved upwardly or downwardly along the first direction. Therefore, though the deposition surface 41 of the substrate 4 is aligned with the third step level 303'a of the first positioning marker 30'a, it is not aligned with the corresponding third step level 303'b of the second positioning marker 30'b. This misalignment can be recognized by an operator or a camera obliquely viewing on the side of the physical vapor deposition system 1' and seeing at least a part of the view illustrated in Fig. 6. In the result, the operator or a controller may control a moving device acting on the crucible 10 such that the tilting of the crucible 10 is eliminated and the deposition surface 41 of the substrate 4 completely aligns with both of thethird step level 303'a and the third step level 303'b.

Exemplary dimensions of the mentioned positioning markers are given in the following table 1, wherein the dimensions of the crucible 10 are as follows: length of the crucible measured along the second direction (x-direction) = 400 mm and depth of the crucible measured along the third direction (y-direction) = 1400 mm

**Table 1**

| Embodiment | Heights of the individual step levels | Lengths of the individual step levels | Depth of the positioning marker |
|---|---|---|---|
| 1 | h₁ = 10mm | L₁ = 50mm | b = 40mm |
| | h₂ = 5mm | L₂ = 50mm | |
| 1' | h'₁ = 10mm | L'₁ = 25mm | |
| | h'₂ =8mm | L'₂ = 25mm | |
| | h'₃ = 6mm | L'₃ = 25mm | |
| | h'₄ =4mm | L'₄ = 25mm | |

Although equally spaced step levels having the same lengths are described with respect to the figures, these positioning markers are only examples, and other positioning markers having different spaces between individual step levels and different lengths of the individual step levels may be provided. Furthermore, other arrangements of the positioning markers with respect to the crucible or to the substrate holder are possible as well as other numbers of step levels or other forms of the crucible and the substrate holder or other arrangements of them within a process chamber.

The embodiments of the invention described in the foregoing description are examples given by way of illustration and the invention is nowise limited thereto. Any modification, variation and equivalent arrangement as well as combinations of embodiments should be considered as being included within the scope of the invention.

### Reference signs

- 1, 1': Physicalvapordepositionsystem
- 10: Crucible
- 101: First surface of the crucible
- 102: Source material
- 103a-103c: Baseofthecrucible
- 20: Substrate holder
- 201: First surface of the substrate holder
- 21a, 21b: Shaft
- 30a: First positioningmarker
- 30b: Second positioningmarker
- 301, 301'a, 301'b: First steplevel
- 302, 302'a: Second steplevel
- 303'a, 303'b: Third steplevel
- 304'a, 304'b: Fourthsteplevel
- 4: Substrate
- 41: Deposition surface
- 5: Processchamber
- 51: Viewport
- 6a, 6b: Moving device

- b: Depth of the positioning marker
- h₁, h'₁: Height of the first step level
- h₂, h'₂: Height of the second step level
- h'₃: Height of the third step level
- h'₄: Height of the fourth step level
- L: Length of the positioning marker
- L₁, L'₁: Length of the first step level
- L₂, L'₂: Length of the second step level
- L'₃: Length of the third step level
- L'₄: Length of the fourth step level
- s: Space between the first step level and the second step level
- x: Second direction
- y: Third direction
- z: First direction

## Claims

1. Physical vapor deposition system (1, 1') comprising a crucible (10) for holding a source material (102), a substrate holder (20) for holding a substrate (4), and a moving device (6a, 6b) for moving the crucible (10) or the substrate holder (20), wherein the moving device (6a, 6b) is suited to change a distance between a first surface (101) of the crucible (10) and a first surface (201) of the substrate holder (20),
the
system (1, 1') being **characterized in that** it further comprises at least one positioning marker (30a, 30b, 30'a, 30'b), which is arranged in a fixed manner at the crucible (10) or at the substrate holder (20) such that it protrudes into a space between the crucible (10) and the substrate holder (20) and which has a stepped contour with at least two different step levels (301, 302, 301'a, 301'b, 302'a), wherein each of the different step levels has an individual height with respect to the first surface (101) of the crucible and is positioned in parallel to the first surface (101) of the crucible (10) if the positioning marker (30a, 30b, 30'a, 30'b) is arranged at the crucible (10) or has an individual height with respect to the first surface (201) of the substrate holder (20) and is positioned in parallel to the first surface (201) of the substrate holder (20) if the positioning marker (30a, 30b, 30'a, 30'b) is arranged at the substrate holder (20), wherein the individual heights are different from each other.

2. Physical vapor deposition system according to claim 1, **characterized in that** it comprises at least a first positioning marker (30a, 30'a) and a second positioning marker (30b, 30'b), wherein the first and the second positioning markers are formed in the same way and are arranged in parallel to each other at opposite sides of the crucible (10) or at opposite sides of the substrate holder (20).

3. Physical vapor deposition system according to claim 2, **characterized in that** the first positioning marker (30a, 30'a) and the second positioning marker (30b, 30'b) are positioned in a shifted manner with respect to each other.

4. Physical vapor deposition system according to any of the previous claims, **characterized in that** the crucible (10), the substrate holder (20) and the positioning marker (30a, 30b, 30'a, 30'b) are positioned in a process chamber (5), **characterized in that** the process chamber (5) has a viewport (51 ) suited for a visual inspection of a position of the first surface (101) of the crucible or of a first surface (201 ) of the substrate holder (20) or of a deposition surface (41) of a substrate (4) when held in the substrate holder (20) with respect to one of the at least two step levels (301, 302, 301'a, 301'b, 302'a) of the positioning marker (30a, 30b, 30'a, 30'b) while the process chamber (4) is closed.

5. A method for adjusting a distance between a crucible (10) and a substrate (4) in a physical vapor deposition system comprising the following steps:
- providing the physical vapor deposition system (1, 1') according to one of claims 1 to 4,
- moving the crucible (10) or the substrate holder (20) such that the first surface (101) of the crucible (10) or the first surface (201) of the substrate holder (20) or a deposition surface (41) of a substrate (4) held in the substrate holder (20) are aligned with one of the step levels (301, 302, 301'a, 301'b, 302'a) of the at least one positioning marker (30a, 30b, 30'a, 30'b) when seen in a side view onthe positioning marker (30a, 30b, 30'a, 30'b) and the crucible (10), the substrate holder (20) or the substrate (4).

## Patentansprüche

1. System zur physikalischen Gasphasenabscheidung (1, 1'), umfassend einen Tiegel (10) zum Aufnehmen eines Ausgangsmaterials (102), einen Substrathalter (20) zum Halten eines Substrates (4) und eine Bewegungsvorrichtung (6a, 6b) zum Bewegen des Tiegels (10) oder des Substrathalters (20), wobei die Bewegungsvorrichtung (6a, 6b) geeignet ist, den Abstand zwischen einer ersten Oberfläche (101) des Tiegels (10) und einer ersten Oberfläche (201) des Substrathalters (20) zu verändern,
**dadurch gekennzeichnet, dass**
das System (1, 1') weiterhin mindestens eine Positionsmarkierung (30a, 30b, 30'a, 30'b) umfasst, die fest mit dem Tiegel (10) oder dem Substrathalter (20) derart angeordnet ist, dass sie in einen Raum zwischen dem Tiegel (10) und dem Substrathalter (20) hineinragt, und die eine stufenförmige Kontur mit mindestens zwei verschiedenen Stufenhöhen (301, 302, 301'a, 301'b, 302'a) aufweist, wobei jede der verschiedenen Stufenhöhen eine individuelle Höhe mit Bezug auf die erste Oberfläche (101) des Tiegels aufweist und parallel zu der ersten Oberfläche (101) des Tiegels (10) angeordnet ist, wenn die Positionsmarkierung (30a, 30b, 30'a, 30'b) an dem Tiegel (10) angeordnet ist, oder eine individuelle Höhe mit Bezug auf die erste Oberfläche (201) des Substrathalters (20) aufweist und parallel zu der ersten Oberfläche (201) des Substrathalters (20) angeordnet ist, wenn die Positionsmarkierung (30a, 30b, 30'a, 30'b) an dem Substrathalter (20) angeordnet ist, wobei die individuellen Höhen voneinander verschieden sind.

2. System zur physikalischen Gasphasenabscheidung nach Anspruch 1, **dadurch gekennzeichnet, dass** es mindestens eine erste Positionsmarkierung (30a, 30'a) und eine zweite Positionsmarkierung (30b, 30'b) umfasst, wobei die erste und die zweite Positionsmarkierung gleichartig ausgebildet und parallel zueinander an entgegengesetzten Seiten des Tiegels (10) oder an entgegengesetzten Seiten des Substrathalters (20) angeordnet sind.

3. System zur physikalischen Gasphasenabscheidung nach Anspruch 2, **dadurch gekennzeichnet, dass** die erste Positionsmarkierung (30a, 30'a) und die zweite Positionsmarkierung (30b, 30'b) in einer versetzten Art und Weise zueinander angeordnet sind.

4. System zur physikalischen Gasphasenabscheidung nach einem der vorhergehenden Ansprüche, **dadurch gekennzeichnet, dass** der Tiegel (10), der Substrathalter (20) und die Positionsmarkierung (30a, 30b, 30'a, 30'b) in einer Prozesskammer (5) angeordnet sind, **dadurch gekennzeichnet, dass** die Prozesskammer (5) ein Sichtfenster (51) aufweist, welches zur optischen Inspektion der Position der ersten Oberfläche (101) des Tiegels oder der ersten Oberfläche (201) des Substrathalters (20) oder einer Abscheideoberfläche (41) eines Substrates (4), wenn dieses in dem Substrathalter (20) gehalten wird, mit Bezug auf eine der mindestens zwei Stufenhöhen (301, 302, 301'a, 301'b, 302'a) der Positionsmarkierung (30a, 30b, 30'a, 30'b) geeignet ist, während die Prozesskammer (4) geschlossen ist.

5. Verfahren zur Einstellung eines Abstandes zwischen einem Tiegel (10) und einem Substrat (4) in einem System zur physikalischen Gasphasenabscheidung, umfassend die folgenden Schritte:
- Bereitstellen eines Systems zur physikalischen Gasphasenabscheidung (1, 1') nach einem der Ansprüche 1 bis 4,
- Bewegen des Tiegels (10) oder des Substrathalters (20) derart, dass die erste Oberfläche (101) des Tiegels (10) oder die erste Oberfläche (201) des Substrathalters (20) oder eine Abscheideoberfläche (41) eines Substrates (4), welches in dem Substrathalter (20) gehalten wird, an einer der Stufenhöhen (301, 302, 301'a, 301'b, 302'a) der mindestens einen Positionsmarkierung (30a, 30b, 30'a, 30'b) in einer Seitenansicht auf die Positionsmarkierung (30a, 30b, 30'a, 30'b) und den Tiegel (10), den Substrathalter (20) oder das Substrat (4) ausgerichtet wird.

## Revendications

1. Système de dépôt physique en phase vapeur (1, 1') comprenant un creuset (10) destiné à contenir un matériau source (102), un porte-substrat (20) destiné à contenir un substrat (4) et un dispositif mobile (6a, 6b) destiné à déplacer le creuset (10) ou le porte-substrat (20), dans lequel le dispositif mobile (6a, 6b) est adapté pour modifier une distance entre une première surface (101) du creuset (10) et une première surface (201) du porte-substrat (20), le système (1, 1') étant **caractérisé en ce qu'**il comprend en outre au moins un marqueur de positionnement (30a, 30b, 30'a, 30'b), qui est disposé de manière fixe au niveau du creuset (10) ou au niveau du porte-substrat (20) de sorte qu'il fait saillie dans un espace entre le creuset (10) et le porte-substrat (20) et qui présente un contour étagé avec au moins deux niveaux d'étagement différents (301, 302, 301'a, 301'b, 302'a), dans lequel chacun des différents niveaux d'étagement a une hauteur individuelle par rapport à la première surface (101) du creuset et est positionné parallèlement à la première surface (101) du creuset (10) si le marqueur de positionnement (30a, 30b, 30'a, 30'b) est disposé au niveau du creuset (10) ou a une hauteur individuelle par rapport à la première surface (201) du porte-substrat (20) et est positionné parallèlement à la première surface (201) du porte-substrat (20) si le marqueur de positionnement (30a, 30b, 30'a, 30'b) est disposé au niveau du porte-substrat (20), dans lequel les hauteurs individuelles sont différentes les unes des autres.

2. Système de dépôt physique en phase vapeur selon la revendication 1, **caractérisé en ce qu'**il comprend au moins un premier marqueur de positionnement (30a, 30'a) et un second marqueur de positionnement (30b, 30'b), dans lequel les premier et second marqueurs de positionnement sont formés de la même manière et sont disposés parallèlement l'un à l'autre sur des côtés opposés du creuset (10) ou sur des côtés opposés du porte-substrat (20).

3. Système de dépôt physique en phase vapeur selon la revendication 2, **caractérisé en ce que** le premier marqueur de positionnement (30a, 30'a) et le second marqueur de positionnement (30b, 30'b) sont positionnés de manière décalée l'un par rapport à l'autre.

4. Système de dépôt physique en phase vapeur selon l'une quelconque des revendications précédentes, **caractérisé en ce que** le creuset (10), le porte-substrat (20) et le marqueur de positionnement (30a, 30b, 30'a, 30'b) sont positionnés dans une chambre de traitement (5), **caractérisé en ce que** la chambre de traitement (5) a une fenêtre d'affichage (51) adaptée pour une inspection visuelle d'une position de la première surface (101) du creuset ou d'une première surface (201) du porte-substrat (20) ou d'une surface de dépôt (41) d'un substrat (4) lorsqu'il est maintenu dans le porte-substrat (20) par rapport à l'un des au moins deux niveaux d'étagement (301, 302, 301'a, 301'b, 302'a) du marqueur de positionnement (30a, 30b, 30'a, 30'b) lorsque la chambre de traitement (4) est fermée.

5. Procédé permettant d'ajuster une distance entre un creuset (10) et un substrat (4) dans un système de dépôt physique en phase vapeur comprenant les étapes suivantes :
- la fourniture du système de dépôt physique en phase vapeur (1, 1') selon l'une des revendications 1 à 4,
- le déplacement du creuset (10) ou du porte-substrat (20) de sorte que la première surface (101) du creuset (10) ou la première surface (201) du porte-substrat (20) ou une surface de dépôt (41) d'un substrat (4) contenu dans le porte-substrat (20) soit alignée avec l'un des niveaux d'étagement (301, 302, 301'a, 301'b, 302'a) de l'au moins un marqueur de positionnement (30a, 30b, 30'a, 30'b) lorsqu'il est vu en vue latérale sur le marqueur de positionnement (30a, 30b, 30'a, 30'b) et le creuset (10), le porte-substrat (20) ou le substrat (4).
